# EUROPÄISCHE PATENTSCHRIFT

(11) **EP 2 341 535 B1**
(45) Veröffentlichungstag und Bekanntmachung des Hinweises auf die Patenterteilung: **04.07.2012**
(21) Anmeldenummer: 10187782.7
(22) Anmeldetag: 15.10.2010
(51) Int. Cl.: H01L 23/48, H01L 25/07

(54) **Druckkontaktiertes Leistungshalbleitermodul mit Hybriddruckspeicher**
Pressure-contacted power semiconductor module with hybrid pressure accumulator
Module semi-conducteur de puissance à contact de pression doté d'un accumulateur de pression hybride

(30) Priorität: 05.12.2009 DE 102009057146
(43) Veröffentlichungstag der Anmeldung: 06.07.2011
(73) Patentinhaber: SEMIKRON Elektronik GmbH & Co. KG, 90431 Nürnberg (DE)
(72) Erfinder: Lederer, Marco, 90453 Nürnberg (DE); Popp, Rainer, 91580 Petersaurach (DE)

(56) Entgegenhaltungen:
- DE-A1- 19 719 703
- DE-A1-102006 006 423
- DE-A1-102006 006 424
- DE-A1-102007 003 587

## Beschreibung

Die Erfindung beschreibt ein Leistungshalbleitermodul in Druckkontaktausführung zur Anordnung auf einem Kühlbauteil. Einen Ausgangspunkt der Erfindung bilden Leistungshalbleitermodule wie sie beispielhaft aus der DE 197 19 703 A1 bekannt sind.

Derartige Leistungshalbleitermodule bestehen nach dem allgemeinen Stand der Technik in der Regel aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher, gegeneinander isolierter, metallischer Leiterbahnen und hierauf befindlichen und mit diesen Leiterbahnen schaltungsgerecht verbundenen Leistungshalbleiterbauelementen. Weiterhin weisen die bekannten Leistungshalbleitermodule Anschlusselemente für externe Last- und Hilfsanschlüsse sowie im Inneren angeordnete Verbindungselemente auf. Diese Verbindungselemente für die schaltungsgerechten internen Verbindungen des Leistungshalbleitermoduls sind häufig als Drahtbondverbindungen ausgebildet.

Ebenfalls bekannt sind druckkontaktierte Leistungshalbleitermodule, wie sie in der DE 10 2006 006 423 A1 offenbart sind. Das Leistungshalbleitermodul gemäß dieser Druckschrift weist eine Druckkontaktausführung zur thermisch leitenden Verbindung des Leistungshalbleitermoduls mit einem Kühlbauteil auf. Ebenso ist in einem derartigen Leistungshalbleitermodul mindestens ein Substrat mit Leistungshalbleiterbauelementen angeordnet. Das Leistungshalbleitermodul weist zudem ein Gehäuse und nach außen führende Last- und Steueranschlusselemente auf. Das Substrat, beispielhaft ein DCB-Substrat, weist einen Isolierstoffkörper auf, auf dessen erster, dem Inneren des Leistungshalbleitermoduls zugewandten, Hauptfläche Leiterbahnen mit Lastpotential angeordnet sind.

Die offenbarten Lastanschlusselemente sind hier jeweils als Metallformkörper mit mindestens einer externen Kontakteinrichtung, einem bandartigen Abschnitt und mit von diesem ausgehenden Kontaktfüßen ausgebildet. Der jeweilige bandartige Abschnitt ist parallel zur Substratoberfläche und von dieser beabstandet angeordnet. Die Kontaktfüße reichen von dem bandartigen Abschnitt zum Substrat und kontaktieren dieses schaltungsgerecht. Zur elektrischen Isolation und Druckweiterleitung zwischen den einzelnen Lastanschlusselementen weisen diese im Bereich der jeweiligen bandartigen Abschnitte jeweils eine elastische Zwischenlage auf.

Die DE 10 2007 003 587 A1 offenbart schließlich ein Leistungshalbleitermodul der oben genannten Art, wobei ein Druckkörper zwischen der Druckeinrichtung und einem nicht direkt benachbarten weiteren Lastanschlusselement angeordnet ist. Hierbei reicht ein Teil dieses Druckkörpers durch das der Druckeinrichtung unmittelbar benachbarte Lastanschlusselement hindurch und übt somit Druck von der Druckeinrichtung direkt auf eine Druckaufnahmestelle dieses weiteren Lastanschlusselement aus.

Die 10 2006006 424 A1 offenbart ein Leistungshalbleitermodul in Druckkontaktausführung nach dem Oberbegriff des Anspruchs 1.

Der Erfindung liegt die Aufgabe zugrunde ein ebenfalls Leistungshalbleitermodul in Druckkontaktausführung vorzustellen, wobei die Einleitung des Drucks auf mindestens ein Lastanschlusselement zu dessen Kontaktierung mit den Leiterbahnen des Substrats auf einfache Weise weiter verbessert wird.

Die Aufgabe wird erfindungsgemäß gelöst, durch ein Leistungshalbleitermodul mit den Merkmalen des Anspruchs 1. Bevorzugte Ausführungsformen sind in den abhängigen Ansprüchen beschrieben.

Der erfinderische Gedanke geht aus von einem auf einer Kühleinrichtung anordenbaren Leistungshalbleitermodul in Druckkontaktausführung mit mindestens einem Substrat, hierauf angeordneten Leistungshalbleiterbauelementen, beispielhaft IGBTs mit antiparallel geschalteten Dioden, einem Gehäuse und nach außen führenden Last- und Steueranschlusselementen. Das Substrat selbst weist hierzu einen Isolierstoffkörper auf und auf dessen erster, dem Inneren des Leistungshalbleitermoduls zugewandten, Hauptfläche Leiterbahnen mit Lastpotential. Weiterhin weist das Substrat vorzugsweise auch mindestens eine Leiterbahn mit Steuerpotential zu Ansteuerung der Leistungshalbleiterbauelemente auf.

Ein erstes, und mindestens ein weiteres Lastanschlusselement des Leistungshalbleitermoduls sind jeweils ausgebildet als Metallformkörper, mit einer Kontakteinrichtung zur externen Verbindung, einem druckübertragenden Abschnitt und mit mindestens einem, von diesem ausgehenden Kontaktfuß. Die jeweiligen druckübertragenden Abschnitte sind hierbei parallel zur Substratoberfläche und von dieser beabstandet angeordnet. Der mindestens ein Kontaktfuß, der von den jeweiligen druckübertragenden Abschnitten ausgeht reicht zum Substrat, und bildet dort schaltungsgerecht den Kontakt des Lastanschlusselements aus. Vorzugsweise kontaktiert der Kontaktfuß hierzu auf dem Substrat die zugeordnete Leiterbahn mit Lastpotential, alternativ auch direkt ein Leistungshalbleiterbauelement.

Die Druckeinrichtung weist zur Druckeinleitung in Richtung des Substrats ein Druckelement auf, das vorzugsweise als Teil des Gehäuses des Leistungshalbleitermoduls ausgebildet ist. Dieses Druckelement leitet den erzeugten Druck, auf den ihm zugewandten druckübertragenden Abschnitt eines Lastanschlusselements, und hierüber auf den druckübertragenden Abschnitt mindestens eines weiteren Lastanschlusselements ein. Erfindungsgemäß ist mindestens ein hybrider, federnder Kunststoffformkörper innerhalb dieser Druckeinrichtung angeordnet. Dieser Kunststoffformkörper ist vorzugsweise flächig ausgebildet und weist zwei Hauptflächen auf, die senkrecht zur Druckrichtung angeordnet sind. Eine bevorzugte Position des Kunststoffformkörpers ist hierbei zwischen dem Druckelement, und dem ihm benachbarten druckübertragenden Abschnitt eines Lastanschlusselements. Eine weitere bevorzugte Position des Kunststoffformkörpers ist hierbei zwischen druckübertragenden Abschnitten, zweier benachbarter Lastanschlusselemente. Es kann besonders vorteilhaft sein, beide Ausgestaltungen gleichzeitig zu wählen.

Der erfindungsgemäß ausgebildete, hybride Kunststoffformkörpers ist hierbei federnd, das heißt elastisch ausgebildet, wobei dieser Kunststoffformkörper mindestens zwei Teilbereiche unterschiedlicher Federkonstante aufweist, wodurch die Federkraft somit an verschiedenen Positionen der lateralen Ausdehnung entlang der Hauptflächen des Kunststoffformkörpers unterschiedlich ist. Hierzu ist es vorteilhaft, wenn der Kunststoffformkörper eine Mehrzahl sich von der ersten, zur zweiten Hauptfläche erstreckende, und sich parallel zu seinen Hauptflächen ausdehnende zweite Teilbereiche aufweist, die eine größere Federkonstante aufweisen, als die dazwischen angeordneten ersten Teilbereiche. Besonders bevorzugt ist es, wenn alle zweiten Teilbereiche bei Draufsicht, auf eine Hauptfläche von einem zusammenhängenden ersten Teilbereich umschlossen sind.

Diese Ausgestaltung weist den Vorteil auf, dass die Kraft der Druckeinrichtung gezielt, an den hierfür notwendigen Stellen verstärkt eingeleitet wird, an denen eine derartige Druckeinleitung notwendig ist, wodurch die Kontaktsicherheit der einzelnen Stromleitenden Verbindungen zwischen einem Lastanschlusselement, also dessen mindestens einen Kontaktfuß, und dem Substrat, also der Leiterbahn oder einem Leistungshalbleiterbauelement, verbessert wird. Hierzu ist es natürlich vorteilhaft diesen zweiten Teilbereich im Wesentlichen in Druckrichtung fluchtend mit den jeweils mindestens einen Kontaktfuß anzuordnen.

Die erfinderische Lösung wird an Hand der Ausführungsbeispiele der Fig. 1 bis 3 weiter erläutert.

Fig. 1 zeigt einen Schnitt durch ein erfindungsgemäßes Leistungshalbleitermodul.

Fig. 2 zeigt eine dreidimensionale Ansicht eines erfindungsgemäßen Leistungshalbleitermoduls.

Fig. 3 zeigt zwei ähnliche Ausgestaltungen einen hybriden, federnden Kunststoffformkörper eines erfindungsgemäßen Leistungshalbleitermoduls.

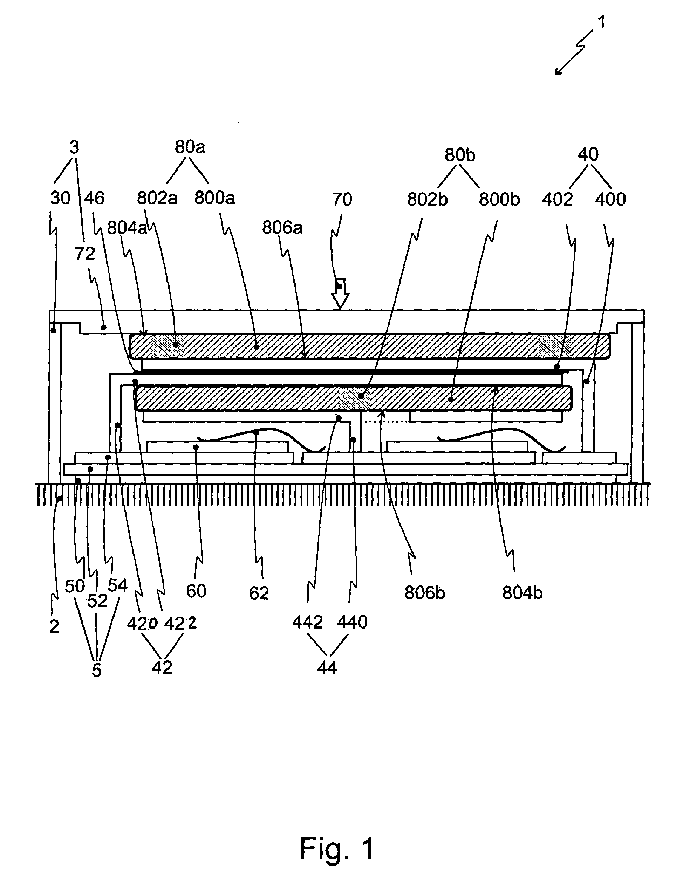

Fig. 1 zeigt einen Schnitt durch ein erfindungsgemäßes Leistungshalbleitermodul (1). Dieses weist ein Gehäuse (3) mit einem rahmenartigen Gehäuseteil (30) auf, der mit einem Kühlbauteil (2) verbindbar ist. Der rahmenartige Gehäuseteil (30) umschließt hierbei das mindestens eine Substrat (5). Dieses wiederum weist einen Isolierstoff körper (52), vorzugsweise eine Isolierkeramik, wie Aluminiumoxid oder Aluminiumnitrit auf.

Auf der, dem Inneren des Leistungshalbleitermoduls (1) zugewandten, ersten Hauptfläche weist das Substrat (5) eine in sich strukturierte Metallkaschierung auf. Die einzelnen Abschnitte dieser vorzugsweise als Kupferkaschierung ausgestalteten Metallkaschierung bilden hierbei die Leiterbahnen (54) des Leistungshalbleitermoduls (1) aus. Die zweite Hauptfläche des Substrats (5) weist gemäß dem Stand der Technik eine nicht strukturierte Kupferkaschierung (50) auf.

Auf den Leiterbahnen (54) des Substrats (5) sind steuerbare, und / oder ungesteuerte Leistungshalbleiterbauelemente (60) wie beispielhaft IGBTs (insulated gate bipolar Transistor) mit jeweils antiparallel geschalteten Freilaufdioden, oder MOS-FETs angeordnet. Diese sind schaltungsgerecht mit weiteren Leiterbahnen (54), beispielhaft mittels Drahtbondverbindungen (62), verbunden.

Die Lastanschlusselemente (40, 42, 44) der verschiedenen notwendigen Potentiale dienen der externen Verbindung der leistungselektronischen Schaltung auf dem Substrat (5) des Leistungshalbleitermoduls (1). Hierzu sind die Lastanschlusselemente (40, 42, 44) als Metallformkörper ausgebildet, die je einen druckübertragenden Abschnitt (402, 422, 442) parallel zur Substratoberfläche aufweisen. Die druckübertragenden Abschnitte (402, 422, 442) bilden hierbei einen Stapel, wobei diese Abschnitte der einzelnen Lastanschlusselemente (40, 42, 44) jeweils gegeneinander elektrisch isoliert sind.

Von den jeweiligen druckübertragenden Abschnitten (402, 422, 442) ragt pro Lastanschlusselement (40, 42, 44) ein Kontaktfuß (400, 420, 440), vorteilhafterweise aber mehrere Kontaktfüße, zu den schaltungsgerecht zugeordneten Leiterbahnen (54) des Substrats (5).

Die schematisch dargestellte Druckeinrichtung (70) zur thermischen Verbindung des Leistungshalbleitermoduls (1) mit einem Kühlbauteil (2) und gleichzeitig zur elektrischen Kontaktierung der Kontaktfüße (400, 420, 440) der Lastanschlusselemente (40, 42, 44) mit den Leiterbahnen (54), des Substrats (5) weist neben den beschrieben druckübertragenden Abschnitten (402, 422, 442) der Lastanschlusselemente noch ein Druckelement (72) zum Druckaufbau auf.

Dieses Druckelement (72) kann gemäß dem Stand der Technik als Kunststoffformkörper mit geeigneter innen liegender Metallseele, und /oder weiteren Versteifungsstrukturen ausgeführt sein. Es ist ebenso bevorzugt, wenn das Druckelement (72) gleichzeitig als Deckel des Leistungshalbleitermoduls (1) und somit als Teil des Gehäuses (3) dient.

Als eine erste erfindungsgemäße Alternative ist hier dargestellt, dass zwischen diesem Druckelement (72) und dem druckübertragenden Abschnitt (402), des im Stapel, des ersten Lastanschlusselements (40) ein Kunststoffformkörper (80a) zur Druckspeicherung und zur gezielten Druckeinleitung auf Teilbereiche des druckübertragenden Abschnitts (402) angeordnet ist. Dieser Kunststoffformkörper (80a) weist einen hybriden Aufbau auf, wobei die gezielte Druckeinleitung durch unterschiedliche Federkonstanten, unterschiedlicher Teilbereiche (800a , 802a) des Kunststoffformkörpers (80a) ausgebildet wird.

Als zweite erfindungsgemäße Alternative ist hier dargestellt, dass zwischen zwei benachbarten, druckübertragenden Abschnitten (422, 442) zweiter Lastanschlusselemente (42, 44), ein derartiger Kunststoffformkörper (80b) angeordnet ist. Selbstverständlich entspricht es ebenso dem Gedanken der Erfindung beide Alternativen gleichzeitig in einem Leistungshalbleitermodul (1) einzusetzen.

In beiden oben genannten Alternativen weist der jeweilig Kunststoffformkörper (80 a/b) eine Mehrzahl sich von der ersten (804 a/b), zur zweiten Hauptfläche (806 a/b) erstreckende, und sich parallel zu diesen Hauptflächen ausdehnende, zweite Teilbereiche (802 a/b) auf, die eine größere Federkonstante aufweisen, als die dazwischen angeordneten ersten Teilbereiche (800 a/b). Somit ergibt sich in der Fläche parallel zum Substrat (5) eine variable Ausgestaltung der Druckkräfte. Besonders vorteilhaft ist die Druckeinleitung, wenn die zweiten Teilbereiche (800, 802) im Wesentlichen in Druckrichtung fluchtend, mit Kontaktfüßen (400, 420, 440) des oder der jeweils darunter liegenden druckübertragenden Abschnitts oder Abschnitte (402, 422, 442) angeordnet sind.

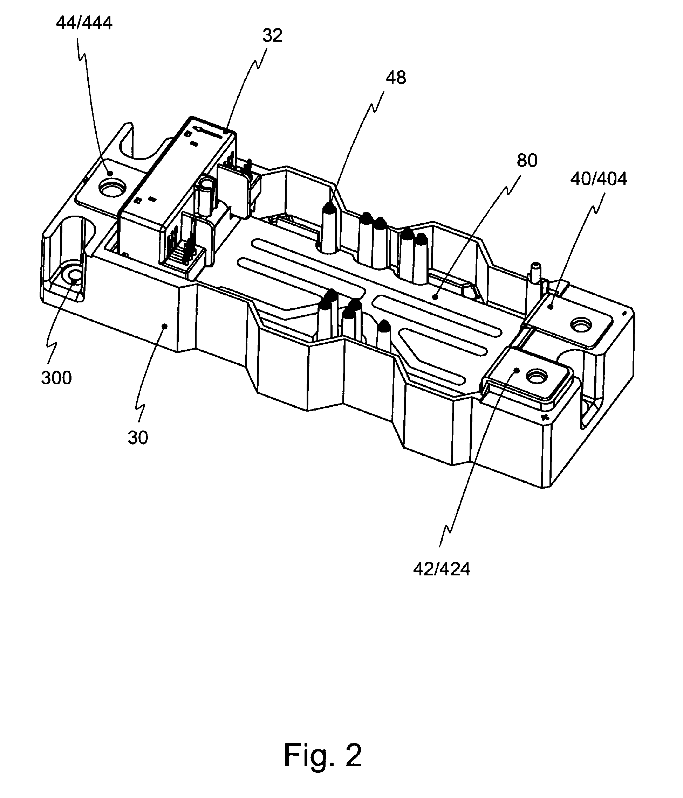

Fig. 2 zeigt eine dreidimensionale Ansicht eines erfindungsgemäßen Leistungshalbleitermoduls (1). Dargestellt ist hier der rahmenartige Gehäuseteil (30) mit Ausnehmungen (300) zur Befestigung auf einer Kühleinrichtung und mit Lastanschlusselementen (40, 42, 44) verschiedener Polarität, wobei hier die externen Verbindungselemente (404, 424, 444) sichtbar sind. Die weitere Ausbildung der Lastanschlusselemente (40, 42, 44) folgt der Beschreibung zur Fig. 1. Dem Lastanschlusselement (44) des Wechselspannungsanschlusses ist noch ein Stromsensor (32) räumlich, und funktional zugeordnet. Weiterhin dargestellt sind als Schraubenfedern, ausgebildete Hilfsanschlusselemente (48) des Leistungshalbleitermoduls (1).

Das nicht sichtbare Substrat (5) ist innerhalb des rahmenartigen Gehäuseteils (30) an dessen Unterseite angeordnet und wird hierbei nicht mittels Befestigungselementen in den dargestellten Ausnehmung (300) des rahmenartigen Gehäuseteils (30) auf eine Kühleinrichtung gedrückt. Für die Druckkontaktierung zur thermisch, leitenden Verbindung des Substrats mit einer Kühleinrichtung und zur elektrisch, leitenden Verbindung der Kontaktfüße (400, 420, 440) der Lastanschlusselemente (40, 42, 44) ist ein nicht dargestelltes Druckelement (72) vorgesehen, das Druck auf die druckübertragenden Abschnitte (402, 422, 442) der Lastanschlusselemente (40, 42, 44), vgl. Fig. 1, überträgt. Dieses Druckelement ist als Teil des Gehäuses und hierbei in der Ausnehmung des rahmenartigen Gehäuseteils (30) angeordnet.

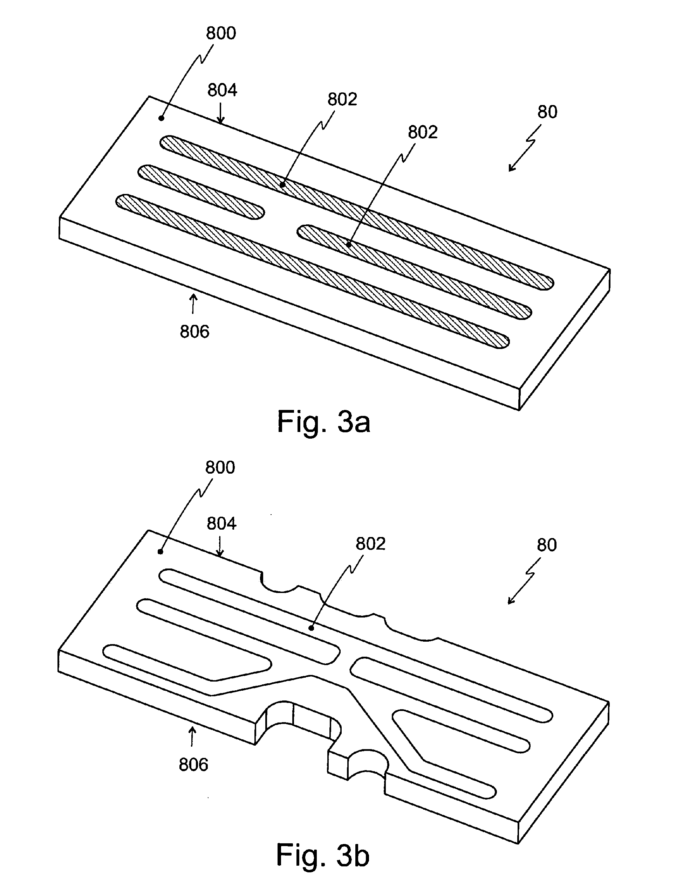

Zwischen dem Druckelement und dem ersten druckübertragenden Abschnitt (402, 422, 442) eines Lastanschlusselements (40, 42, 44) ist erfindungsgemäß ein hybrider, federnder Kunststoffformkörper (80) zur, über die Fläche parallel zum Substrat betrachtet, variablen druckübertragung vorgesehen. Weitere Einzelheiten des Kunststoffformkörpers sind in Fig. 3 beschrieben.

Fig. 3 zeigt zwei Ausgestaltungen eines hybriden, federnden Kunststoffformkörper (80) eines erfindungsgemäßen Leistungshalbleitermoduls (1). Der Kunststoffformkörper gemäß Fig. 3a ist quaderförmiger ausgebildet und weist einen ersten Teilbereich (800) mit einer ersten Federkonstante auf. Von diesem ersten Teilbereich (800) jeweils aus Sicht auf eine der beiden Hauptflächen (804, 806) umschlossen sind zweite Teilbereiche (802) zweiter, größerer Federkonstante.

Die beiden Hauptflächen des Kunststoffformkörpers sind im unkomprimierten Zustand eben ausgebildet, wodurch sich eine konstante Dicke des Kunststoffformkörpers ergibt. Es kann allerdings ebenso vorteilhaft sein, wenn im unkomprimierten Zustand die unterschiedlichen Teilbereiche, unterschiedliche Dicken aufweisen, wodurch die Hauptflächen nicht vollständig eben ausgebildet sind. Es ist allerdings bevorzugt, wenn Schwankung der Dicke des Kunststoffformkörpers im unkomprimierten Zustand, in den jeweiligen Teilbereichen einen Maximalwert ±10% der mittleren Dicke nicht überschreitet.

Fig. 3b zeigt eine weitere Ausgestaltung des hybriden, federnden Kunststoffformkörpers (80) mit zwei Teilbereichen unterschiedlicher Federkonstante. Der Kunststoffformkörper (80) selbst ist im Wesentlichen wieder quaderförmig ausgebildet, und weist an denjenigen Stellen, vgl. Fig. 2, an denen Hilfsanschlusselemente (48) im Leistungshalbleitermodul vorgesehen sind, Ausnehmungen auf.

Der dargestellte Kunststoffformkörper (80) weist gewissermaßen einen Grundkörper mit einer ersten Federkonstante auf, der den ersten Teilbereich (800) ausbildet. Dieser umschließt in der Draufsicht hier nur einen zweiten, gewissermaßen Finger ausbildenden, Teilbereich (802) mit größerer Federkonstante vollständig. Diese Ausgestaltung weist den Vorteil der einfacheren Herstellbarkeit auf gegenüber einer Mehrzahl von lokal enger begrenzten zweiten Teilbereichen, gemäß Fig. 3a. Die jeweiligen Teilbereiche erstrecken sich hierbei durch das Volumen des Kunststoffformkörpers von der ersten (804), zur zweiten (806) Hauptfläche, vgl. auch Fig. 1.

Der jeweilige Kunststoffformkörper (80) selbst besteht vorteilhafterweise aus einem geschlossenzelligen Schaumstoff, oder einem Integralschaum, die sich mittels bekannter Verfahren derart herstellen lassen, das sie elastisch ausgebildet sind und somit eine definierte Federkonstante aufweisen. Zur Ausbildung der unterschiedlichen Teilbereiche kann es vorteilhaft sein, den Schaumstoff bzw. den Integralschaum mit unterschiedlicher Dichte und / oder unterschiedlicher Zellgröße auszubilden. Hierdurch erhalten die verschiedenen Teilbereiche (800, 802) ihre unterschiedliche Federkonstante.

## Patentansprüche

1. Leistungshalbleitermodul (1) in Druckkontaktausführung mit mindestens einem Substrat (5), hierauf angeordneten Leistungshalbleiterbauelementen (60), einem Gehäuse (3) und nach außen führenden Lastanschlusselementen (40, 42, 44) und mit einer ein Druckelement (72) aufweisenden Druckeinrichtung (70), wobei das Substrat (5) auf seiner ersten dem Inneren des Leistungshalbleitermoduls zugewandten Hauptfläche Leiterbahnen (54) mit Lastpotential aufweist,
wobei ein erstes (40) und mindestens ein weiteres Lastanschlusselement (42, 44) jeweils als Metallformkörper mit einem druckübertragenden Abschnitt (402, 422, 442) und jeweils mindestens einem von diesem ausgehenden Kontaktfuß (400, 420, 440) ausgebildet ist, der jeweilige druckübertragenden Abschnitt (402, 422, 442) annähernd parallel zur Substratoberfläche und von dieser beabstandet angeordnet ist und die Kontaktfüße (400, 420, 440) von dem druckübertragenden Abschnitt (402, 422, 442) zum Substrat (5) reichen und dieses schaltungsgerecht kontaktieren, **dadurch gekennzeichnet, dass**
die Druckübertragung von dem Druckelement (72), auf den ersten druckübertragenden Abschnitt (402) und / oder zwischen mindestens einem druckübertragenden Abschnitt (422) auf einen weiteren benachbarten druckübertragenden Abschnitt (442) mittels eines hybriden, federnden Kunststoffformkörpers (80) mit mindestens zwei Teilbereichen (800, 802) unterschiedlicher Federkonstante ausgebildet ist, wobei der Kunststoffformkörper (80) zur, über die Fläche parallel zum Substrat (5) betrachtet, variablen Druckübertagung vorgesehen ist.

2. Leistungshalbleitermodul (1) nach Anspruch 1, wobei
der Kunststoffformkörper (80) im unkomprimierten Zustand, in allen Teilbereichen (800, 802) eine konstante Dicke, und somit zwei parallele Hauptflächen (804, 806) aufweist.

3. Leistungshalbleitermodul (1) nach Anspruch 1, wobei
der Kunststoffformkörper (80) im unkomprimierten Zustand in den jeweiligen Teilbereichen (800, 802) eine unterschiedliche Dicke mit einer Schwankung von maximal ±10% der mittleren Dicke, und somit weitgehend parallele Hauptflächen aufweist.

4. Leistungshalbleitermodul (1) nach Anspruch 2 oder 3, wobei
der Kunststoffformkörper (80) eine Mehrzahl sich von der ersten, zur zweiten Hauptfläche (804, 806) erstreckende, und sich parallel zu diesen Hauptflächen ausdehnende, zweite Teilbereiche (802) aufweist, die eine größere Federkonstante aufweisen, als die dazwischen angeordneten ersten Teilbereiche (800).

5. Leistungshalbleitermodul (1) nach Anspruch 4, wobei
die ersten Teilbereiche (800) eine geringere Federkonstante aufweisen als die zweiten Teilbereiche (802).

6. Leistungshalbleitermodul (1) nach Anspruch 4, wobei
alle zweiten Teilbereiche (802) bei Draufsicht auf eine Hauptfläche (804, 806) von einem ersten Teilbereich (800) umschlossen sind.

7. Leistungshalbleitermodul (1) nach Anspruch 1, wobei
die zweiten Teilbereiche (802) im Wesentlichen in Druckrichtung fluchtend mit Kontaktfüßen (400, 420, 440) angeordnet sind.

8. Leistungshalbleitermodul (1) nach Anspruch 1, wobei
der Kunststoffformkörper (80) aus einem geschlossenzelligen Schaumstoff, oder einem Integralschaum besteht.

9. Leistungshalbleitermodul (1) nach Anspruch 8, wobei
die unterschiedliche Federkonstante ausgebildet wird durch eine unterschiedliche Dichte des Schaumstoffes des jeweiligen Teilbereiches (800, 802).

10. Leistungshalbleitermodul (1) nach Anspruch 8, wobei
die unterschiedliche Federkonstante ausgebildet wird durch eine unterschiedliche Zellgröße des Schaumstoffes des jeweiligen Teilbereiches (800, 802).

## Claims

1. A pressure-contacted power semiconductor module (1) with at least one substrate (5) having power semiconductor components (60) disposed thereon, a housing (3) and load connection elements (40, 42, 44) leading to the outside and with a pressure device (70) comprising a pressure element (72), wherein the substrate (5), on its first main surface facing the inside of the power semiconductor module, comprises conductor tracks (54) with a load potential,
wherein one first (40) and at least one further load connection element (42, 44) are formed as a plastic moulding with a pressure-transferring section (402, 422, 442) and at least one contact pin (400, 420, 440), respectively, extending therefrom, the respective pressure-transferring section (402, 422, 442) is arranged approximately in parallel with the substrate surface and spaced apart therefrom, and the contact pins (400, 420, 440) reach from the pressure-transferring section (402, 422, 442) to the substrate (5) and contact the same in a circuit-appropriate manner,
**characterised in that**
pressure transfer from the pressure element (72) to a first pressure-transferring section (402) und/or between at least one pressure-transferring section (422) to a further adjacent pressure-transferring section (442) is implemented by means of a hybrid, elastic plastic moulding (80) with at least two partial area (800, 802) having a different spring constant, wherein the plastic moulding (80) is provided for a variable pressure transfer when viewed across the surface in parallel with the substrate (5).

2. Power semiconductor module (1) according to claim 1, wherein the plastic moulding (80), in its uncompressed state, comprises a constant thickness in all partial areas (800, 802) and thus two parallel main surfaces (804, 806).

3. Power semiconductor module (1) according to claim 1, wherein the plastic moulding (80), in its uncompressed state, comprises a different thickness in the respective partial areas (800, 802) with the mean thickness varying by maximally ±10%, and thus substantially parallel main surfaces.

4. Power semiconductor module (1) according to claim 2 or 3, wherein the plastic moulding (80) comprises a plurality of second partial areas (802) extending from the first to the second main surface (804, 806) and in parallel with these main surfaces, which second partial areas comprise a larger spring constant than the first partial areas (800) arranged in between.

5. Power semiconductor module (1) according to claim 4, wherein the first partial areas (800) comprise a smaller spring constant than the second partial areas (802).

6. Power semiconductor module (1) according to claim 4, wherein all second partial areas (802), when looking at the top of one main surface (804, 806) are enclosed by a first partial area (800).

7. Power semiconductor module (1) according to claim 1, wherein the second partial areas (802) are substantially aligned in pressure direction with contact pins (400, 420, 440).

8. Power semiconductor module (1) according to claim 1, wherein the plastic moulding (80) consists of a closed-cell-type foamed material or an integral foam.

9. Power semiconductor module (1) according to claim 8, wherein the different spring constant is implemented by a different thickness of the foamed material of the respective partial area (800, 802).

10. Power semiconductor module (1) according to claim 8, wherein the different spring constant is implemented by a different cell size of the foamed material of the respective partial area (800, 802).

## Revendications

1. Module à semi-conducteurs de puissance (1) dans une version à contact de pression comprenant au moins un substrat (5), des composants à semi-conducteurs de puissance (60) disposés dessus, un boîtier (3) et des éléments de raccordement de charge (40, 42, 44) allant vers l'extérieur et un dispositif de pression (70) présentant un élément de pression (72), le substrat (5) présentant sur sa première surface principale tournée vers l'intérieur du module à semi-conducteurs de puissance des pistes conductrices (54) avec potentiel de charge,
un premier (40) et au moins un autre élément de raccordement de charge (42, 44) étant conçus à chaque fois sous forme de corps moulé en métal avec une partie (402, 422, 442) transmettant la pression et à chaque fois au moins un pied de contact (400, 420, 440) partant de cette partie, laquelle partie (402, 422, 442) respective transmettant la pression étant disposée approximativement parallèlement à la surface du substrat et à distance de celle-ci et les pieds de contact (400, 420, 440) allant de la partie (402, 422, 442) transmettant la pression au substrat (5) et mettant en contact ce substrat de façon conforme au circuit,
**caractérisé en ce que**
la transmission de pression de l'élément de pression (72) à la première partie (402) transmettant la pression et/ou entre au moins une partie (422) transmettant la pression à une autre partie (442) voisine et transmettant la pression est conçue au moyen d'un corps moulé en matière synthétique (80) hybride et faisant ressort comprenant au moins deux zones partielles (800, 802) présentant une constante de rappel différente, le corps moulé en matière synthétique (80) étant prévu pour la transmission de pression variable, vu par rapport à la surface parallèlement au substrat (5).

2. Module à semi-conducteurs de puissance (1) selon la revendication 1, le corps moulé en synthétique (80) présentant dans l'état comprimé, dans toutes les zones partielles (800, 802) une épaisseur constante, et donc deux surfaces principales (804, 806) parallèles.

3. Module à semi-conducteurs de puissance (1) selon la revendication 1, le corps moulé en matière synthétique (80) présentant dans l'état non comprimé dans les zones partielles (800, 802) respectives une épaisseur différente avec variation maximale de ±10 % de l'épaisseur moyenne, et donc surfaces principales largement parallèles.

4. Module à semi-conducteurs de puissance (1) selon la revendication 2 ou 3, le corps moulé en matière synthétique (80) présentant une pluralité de secondes zones partielles (802), s'étendant depuis la première surface principale jusqu'à la seconde surface principale (804, 806) et s'étirant parallèlement à ces surfaces principales, lesquelles zones présentent une constante de rappel plus grande que les premières zones partielles (800) intercalées.

5. Module à semi-conducteurs de puissance (1) selon la revendication 4,
les premières zones partielles (800) présentant une constante de rappel plus faible que les secondes zones partielles (802).

6. Module à semi-conducteurs de puissance (1) selon la revendication 4, toutes les secondes zones partielles (802) étant entourées en vue de dessus d'une surface principale (804, 806) par une première zone partielle (800).

7. Module à semi-conducteurs de puissance (1) selon la revendication 1, les secondes zones partielles (802) étant disposées principalement dans le sens de pression en alignement avec les pieds de contact (400, 420, 440).

8. Module à semi-conducteurs de puissance (1) selon la revendication 1, le corps moulé en matière synthétique (80) étant à base d'un produit alvéolaire à cellules fermées, ou à base d'une mousse intégrale.

9. Module à semi-conducteurs de puissance (1) selon la revendication 8, la constante de rappel différente étant réalisée par une densité différente du produit alvéolaire de la zone partielle (800, 802) respective.

10. Module à semi-conducteurs de puissance (1) selon la revendication 8, la constante de rappel différente étant conçue par une grandeur de cellule différente de celle du produit alvéolaire de la zone partielle (800, 802) respective.
